# FASCICULE DE BREVET EUROPEEN

(11) **EP 2 333 566 B1**
(45) Date de publication et mention de la délivrance du brevet: **08.08.2018**
(21) Numéro de dépôt: 10354074.6
(22) Date de dépôt: 15.11.2010
(51) Int. Cl.: G01R 22/06

(54) **Appareil électrique de mesure avec deux possiblilités de raccordement**
Elektrisches Messgerät mit zwei Möglichkeiten zum Anschluss
Electrical measurement apparatus having two possibilities of connection

(30) Priorité: 11.12.2009 FR 0905986
(43) Date de publication de la demande: 15.06.2011
(73) Titulaire: Schneider Electric Industries SAS, 92500 Rueil-Malmaison (FR)
(72) Inventeur: Boumegoura, Tarek, 38050 Grenoble Cedex 9 (FR); Gufflet, Didier, 38050 Grenoble Cedex 9 (FR); Wang, Hao, 38050 Grenoble Cedex 9 (FR); Wang, Shunyao, 38050 Grenoble Cedex 9 (FR)
(74) Mandataire: Colette, Marie-Françoise

(56) Documents cités:
- EP-A1- 1 120 659
- WO-A1-94/27157
- FR-A- 1 059 122
- US-A- 5 853 300
- US-B1- 6 254 437

## Description

### DOMAINE TECHNIQUE

L'invention concerne le raccordement au réseau électrique d'appareils de mesure et de compteurs d'énergie, notamment modulaires. L'invention concerne plus particulièrement un appareil de mesure de grandeurs électriques circulant dans un conducteur de ligne couplé par des bornes de raccordement à vis.

### ETAT DE LA TECHNIQUE

Les installations électriques domestiques, tertiaires ou les réseaux industriels peuvent comprendre des appareils de mesure de paramètres du courant électrique ; ainsi, le compteur d'énergie est traversé par un conducteur de la ligne électrique dont la tension est également mesurée pour estimer la consommation énergétique et/ou les différents paramètres électriques. Deux types de montage coexistent : les appareils de mesure dits à câbles traversant sont « enfilés » directement sur les câbles de la ligne ; d'autres compteurs comprennent des bornes de raccordement pour les extrémités sectionnées des conducteurs de la ligne et un pont adapté les relie à travers le dispositif de mesure, par exemple un tore transformateur de courant.

Selon la configuration et la mise en place de la ligne, un seul des deux types de compteurs est sélectionné, ce qui implique un doublement du nombre de références pour l'industriel et un choix précoce du type de montage pour l'installateur ; par ailleurs, si le compteur doit être déconnecté puis rebranché, il doit éventuellement être changé au vu de la modification du raccordement. Pour éviter cet inconvénient, le document EP 1 120 659 A1, qui divulgue le préambule de la revendication 1, propose un appareil de mesure dans lequel une tige conductrice relie les bornes et traverse de part en part l'appareil de mesure qui accepte ainsi les raccordements par câble traversant et par câble non traversant couplé aux bornes.

Cependant, cette solution entraîne une diminution de l'espace résiduel disponible au niveau des bornes de raccordement. La section des câbles en montage traversant est donc limitée pour une même gamme de compteur, sauf à les dénuder pour les raccorder aux bornes.

### EXPOSE DE L'INVENTION

Parmi d'autres avantages, l'invention vise à pallier des inconvénients des compteurs d'énergie existants. Plus généralement, l'invention propose un appareil de mesure acceptant des câbles d'une même section, en particulier élevée, en raccordement traversant ou non.

Sous un aspect, l'invention concerne un appareil de mesure d'une grandeur électrique comprenant des bornes d'entrée et de sortie à organe de serrage, notamment à vis ; de préférence, l'appareil de mesure comprend une pluralité de paires de bornes, et notamment quatre pour une alimentation triphasée avec neutre. Entre les bornes de l'appareil sont définis des passages de conducteur de courant qui sont associés à des moyens de mesure d'une grandeur, ou paramètre, représentative du courant circulant dans le passage ou dans la ligne complète. En particulier, les moyens de mesure comprennent un dispositif de mesure de l'intensité, notamment un tore transformateur pour chaque passage, associé à des moyens de traitement, par exemple une carte électronique. Les moyens de mesure peuvent également comprendre un dispositif de mesure de la tension associé à des moyens de traitement. De préférence, le dispositif de mesure de la tension est une vis qui peut être serrée sur le passage de conducteur de courant, et notamment est adaptée à percer l'isolant d'un câble s'y trouvant. Avantageusement, une telle vis de type pointeau est mise en place sur une des bornes de chaque paire pour simplifier le montage de l'appareil et pour plus de précision dans la localisation de l'éventuel perçage de la gaine d'un câble.

Par souci de simplification, l'appareil de mesure peut par ailleurs être monté par mise en place dans un châssis adapté des dispositifs de mesure, emboîtement d'un deuxième châssis sur le premier pour loger de façon stable et précise les dispositifs de mesure et autres composants, puis mise en place des moyens électroniques de traitement, de façon à former un coeur de produit qui peut être placé directement dans un boîtier.

Pour permettre, avec le même appareil, un raccordement par câbles traversant ou non, l'appareil de mesure selon l'invention est doté d'un élément conducteur qui peut être mis en place dans le passage de conducteur de courant, entre les deux bornes, pour le raccordement de deux extrémités de câbles sectionnées. L'élément conducteur, de type lame ou barre, est de préférence un profilé métallique avec deux parties d'extrémité incurvées de façon à loger les extrémités de câbles de façon centrée ; la partie des bornes recevant la partie d'extrémité de la barre conductrice est de préférence de forme adaptée et complémentaire pour assurer une mise en place précise de la barre dans les bornes. Par ailleurs, pour un montage imperdable ou fixe, l'une des extrémités de la barre peut comprendre des ailettes et la cage des bornes est munie d'évidements coopérant avec les ailettes pour stabiliser l'ensemble. De préférence, pour éviter toute chute lors d'un montage vertical de l'appareil de mesure, les barres sont configurées de sorte qu'elles ne peuvent traverser la borne ; ainsi, la barre ne peut être insérée que dans un sens, correspondant au haut vers le bas en position montée de l'appareil, et ne peut tomber.

Selon l'invention, la barre conductrice est en outre configurée pour obstruer, ou boucher, le passage de conducteur de courant entre les bornes lorsqu'elle est mise en place, c'est-à-dire qu'un câble ne peut pas être inséré dans le passage. En particulier, la barre comprend une partie intermédiaire décalée par rapport, par exemple parallèle, à l'alignement entre les parties d'extrémité, de préférence d'une distance égale à la largeur du passage de conducteur de courant. Avantageusement, la partie intermédiaire est séparée des parties d'extrémité par des portions orthogonales à l'alignement précité, lesdites portions formant des butées pour les extrémités de câbles lors du raccordement, de sorte que la longueur de câble insérée dans l'appareil de mesure est fixée. Dans un mode de réalisation préféré, la barre est en forme de oméga, avec une partie intermédiaire parallèle aux parties d'extrémité ; la partie intermédiaire est avantageusement munie de moyens de solidarisation, notamment des ouvertures complémentaires d'ergots situés dans le passage des dispositifs de mesure.

Sous un autre aspect, l'invention est relative à un compteur d'énergie qui correspond à un tel appareil de mesure avec un dispositif de mesure de courant et un dispositif de mesure de la tension pour chaque phase, et une carte électronique commune de traitement des informations.

### BREVE DESCRIPTION DES FIGURES

D'autres avantages et caractéristiques ressortiront plus clairement de la description qui suit de modes particuliers de réalisation de l'invention, donnés à titre illustratif et nullement limitatifs, représentés dans les figures annexées.
La figure 1 illustre schématiquement un compteur électrique.
Les figures 2A, 2B, 2C et 2D montrent des éléments du système de connexion selon un mode de réalisation préféré de l'invention.
La figure 3 illustre un montage préféré d'un compteur selon l'invention.
Les figures 4A et 4B représentent le raccordement à câble traversant et non traversant dans un compteur selon un mode de réalisation de l'invention.

### DESCRIPTION DETAILLEE D'UN MODE DE REALISATION PREFERE

Un compteur d'énergie électrique 1 comprend un boîtier 2 solidarisé usuellement sur une paroi verticale, en particulier par un aménagement approprié sur une paroi de fond pour un engagement sur un rail de montage 4. Par souci de simplification de la présentation d'un mode de réalisation préféré de l'invention, les éléments composant l'appareil de mesure 1 seront décrits en relation avec cette position d'utilisation ; l'utilisation des termes relatifs de position, tels que « latéral », « supérieur », « fond », etc., ne doit pas être interprétée comme un facteur limitant.

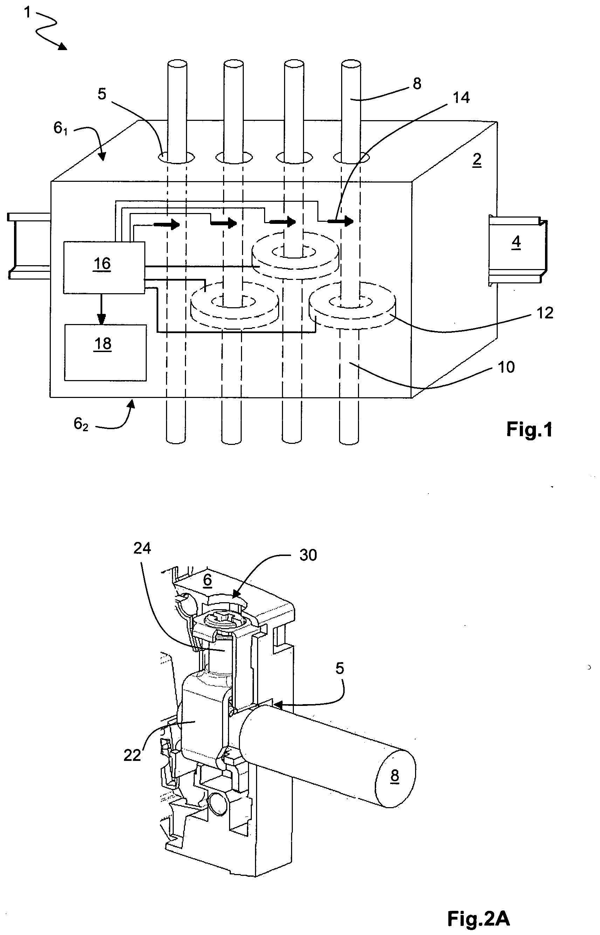

Selon un mode de réalisation préféré de l'invention schématisé en figure 1, le compteur électrique 1 est raccordé via des orifices 5 adaptés dans ses faces supérieure 6₁ et inférieure 6₂ à un réseau de distribution tétraphasé, avec alimentation par trois conducteurs de phase et un conducteur de neutre verticaux. La section des conducteurs, ou câbles, 8 est normalisée en fonction de l'intensité du courant y circulant ; en particulier, selon l'invention, l'appareil de mesure 1 est un compteur de puissance, adapté pour une intensité pouvant atteindre 125 A, avec des câbles 8 de section jusque 35 mm², voire 50 mm², c'est-à-dire des câbles 8 de section élevée compte tenu du faible espace résiduel dans la lumière de passage du câble.

Un passage conducteur 10 relie les deux faces 6 d'entrée et sortie des conducteurs 8, pour former une ligne 8, 10 quel que soit le mode de montage des câbles 8 au sein de l'appareil de mesure 1 ; le passage conducteur 10 traversant le boîtier 2 est associé à des moyens de détermination d'une grandeur électrique. En particulier, chaque ligne 8, 10 (excepté le neutre) traverse un tore de détection de l'intensité du courant 12, et est connectée à des moyens de mesure de la tension 14 ; chacun des dispositifs de mesure 12, 14 est associé à des moyens de traitement 16 des signaux mesurés pour donner l'information correspondante. Selon le mode de réalisation préféré, une même carte électronique 16 permet le traitement des informations relatives à la tension et au courant, et des moyens de visualisation 18, par exemple en face avant du compteur 1, permettent à l'utilisateur d'utiliser les différents paramètres mesurés et calculés du réseau.

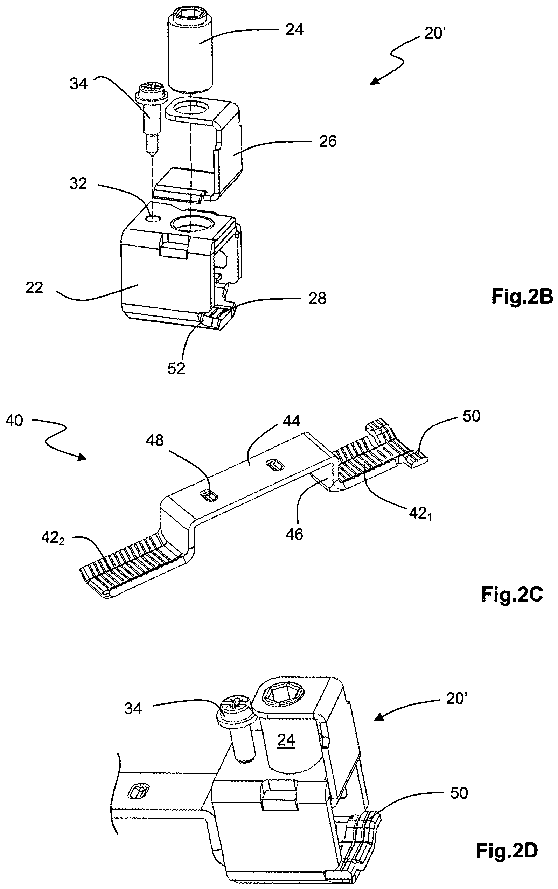

Le compteur 1 est adapté au montage à câbles 8 non traversant : les câbles 8 sont alors, tel qu'usuel, dénudés et insérés dans des bornes 20 du compteur 1, bloquées dans des logements adaptés du boîtier 2 duquel elles débouchent par les quatre orifices 5, de préférence alignés, de chaque face horizontale 6. Tel qu'illustré en figure 2A, chaque borne 20 comprend une cage 22 destinée à recevoir le câble 8, et un organe de serrage 24, qui comprend classiquement une vis 24 dotée d'un cavalier 26 plat à une extrémité qui augmente la surface de serrage vers une paroi 28 de la cage 22. Un orifice 30 localisé sur la face avant du boîtier 2 permet le maintien du câble 8 par la vis de serrage 24 dans le fond 28 de la cage 22.

Selon un mode de réalisation préféré, le dispositif de prise de la tension 14 est localisé au niveau des bornes 20 afin d'agir directement sur le câble 8. Le dispositif de mesure de la tension 14 peut comprendre une vis de type pointeau associée à une cage jouxtant la borne 20 (non illustré) ; de préférence, tel qu'illustré en figure 2B, il est intégré à l'une des bornes 20', de préférence à la borne 20' localisée sur la face supérieure 6₁. En particulier, un trou fileté 32 est ménagé dans la cage 22, perpendiculairement à l'axe du passage de câble 8, pour une vis pointeau 34, qui est de préférence montée imperdable. De préférence les vis pointeau 34 et de serrage 24 sont côte à côte, en regard de la surface de serrage 28, et un orifice 30' sur la face avant permet d'actionner le dispositif de mesure de la tension 34 pour réaliser un contact électrique avec le câble 8 logé dans la borne 20', le cas échéant en perforant l'isolant entourant ledit câble 8.

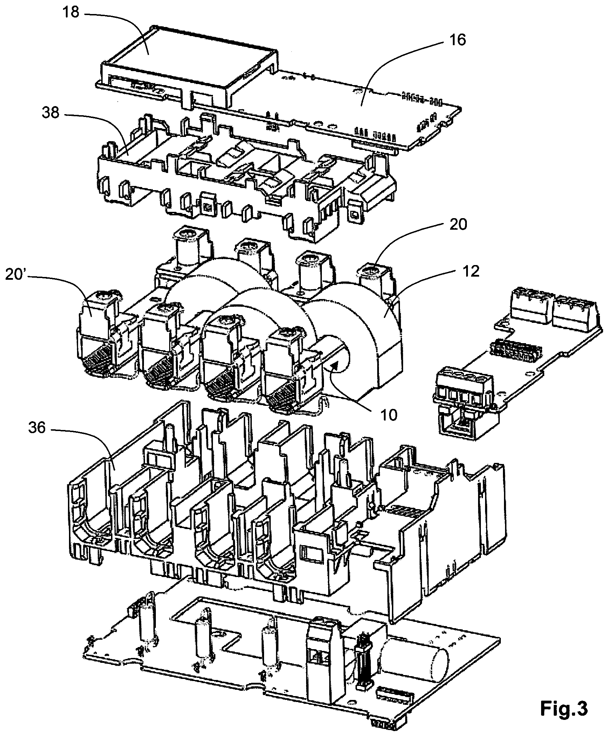

Dans un mode de fabrication avantageux illustré en figure 3, le compteur 1 est assemblé par emboîtement d'une superposition d'éléments constitutifs. En particulier, un premier châssis de fond 36 est moulé en plastique avec des aménagements dans lesquels sont positionnés les bornes 20, 20' et les dispositifs de mesure du courant 12, de préférence des tores enrobés en résine, qui sont avantageusement disposés en quinconce de façon à restreindre l'encombrement du compteur 1 ; d'autres éléments peuvent être associés. Un deuxième châssis 38 comprenant des aménagements correspondants est ensuite mis en place au-dessus du premier châssis 36, pour refermer les logements autour des éléments constitutifs 14, 20, 20' et former un ensemble emboîté solidaire : ce mode de réalisation, simple, permet un positionnement stable et précis des différents éléments constitutifs, en particulier en centrant les capteurs de courant 12 autour des passages 10 de la ligne conductrice. Par ailleurs, sur sa face opposée, le deuxième châssis 38 comprend des logements pour les moyens électroniques de traitement 16 et pour un écran de visualisation 18 qui y sont couplés, ce qui permet de réaliser les connexions électroniques de façon retardée et dans l'environnement adapté. Le coeur de produit ainsi formé peut être mis en place dans un boîtier moulé 2 de façon usuelle.

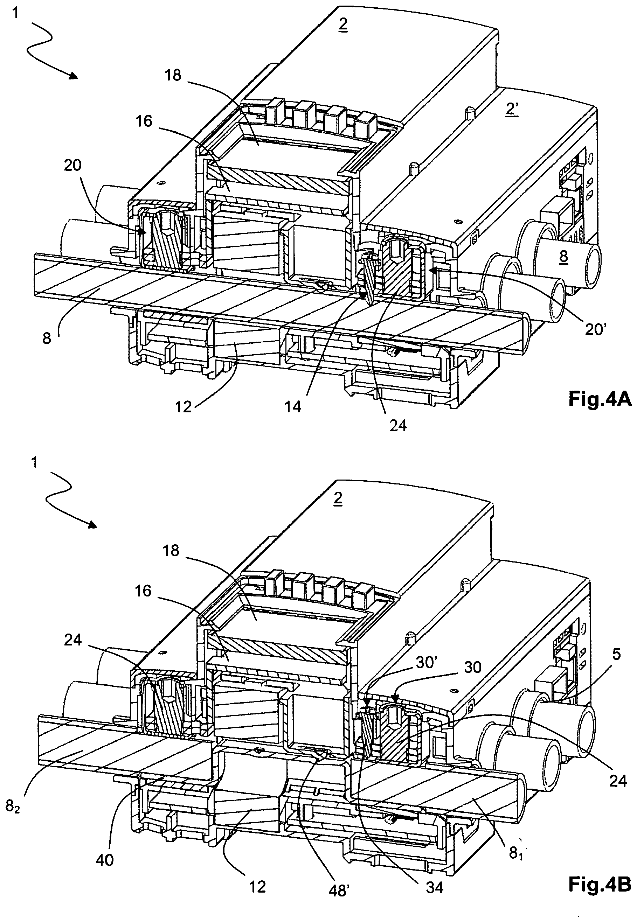

Le compteur 1 ainsi assemblé peut être utilisé directement pour les câbles traversant 8 (figure 4A) : les câbles 8 sont insérés dans les orifices de la face supérieure 6₁ pour ressortir par la face inférieure 6₂ via le passage de conducteur 10, formant par là la ligne conductrice qui traverse le tore de détection 12. Un serrage de la vis 24 des bornes 20, 20' permet un maintien du câble 8 en position dans le compteur 1, et un actionnement de la vis pointeau 34 perce l'isolant du câble 8 pour communiquer à la carte électronique 16 les informations relatives à la tension. Un capot 2' peut recouvrir les orifices fonctionnels 30, 30' une fois les éléments 24, 34 mis en place.

Selon l'invention, ce même compteur 1 peut être utilisé pour des câbles 8 non traversant, pour lesquels il importe de réaliser la conduction électrique entre les deux bornes opposées 20, 20', par insertion d'un élément conducteur 40 réalisant la connexion électrique dans le passage 10 entre les deux extrémités 8₁, 8₂ de câble 8. Selon l'invention, l'élément conducteur 40 permet une connexion directe sur les câbles 8 et un positionnement optimum de leurs extrémités 8ᵢ, tout en obstruant le passage dans les tores de mesure 12 afin d'éviter toute confusion dans le mode de raccordement et toute intrusion.

En particulier, selon un mode de réalisation préféré illustré en figure 2C, l'élément conducteur 40 est une lame ou barre en profilé métallique insérée dans les bornes 20, 20' pour une connexion directe. Pour conserver une ouverture maximale de la cage 22 pour le passage d'un câble 8, la barre 40 est de faible épaisseur, sa section étant adaptée pour conduire les courants élevés et supporter les courants de court-circuit avant intervention des disjoncteurs, ce qui assure la continuité de service. Afin que l'extrémité 8ᵢ de câble se loge de façon précise et centrée dans la lame 40 pour un serrage optimal, à ses parties d'extrémité 42ᵢ, le profilé du conducteur 40 est incurvé, en V ou en U ; pour une mise en place centrée de la lame 40, la cage 22 des bornes est adaptée, avec une forme de la paroi de serrage 28 (opposée au cavalier 26) complémentaire à celle de la partie d'extrémité 42 du profilé.

Par ailleurs, afin d'obstruer le passage sans perturber la conduction électrique, la barre 40 comprend une partie intermédiaire 44 décalée par rapport au plan formé par ses parties d'extrémités 42, d'une distance correspondant de préférence au passage de courant 10 prévu dans le boîtier 2, en particulier au diamètre interne du tore de détection 12. Selon un mode de réalisation non illustré, pour augmenter la précision de la mesure, la lame 40 mise en place est localisée au centre de l'ouverture du tore de détection 12, avec par exemple un profil sensiblement en M.

Dans un mode de réalisation avantageux, la barre 40 est configurée en créneau, ou en oméga, avec une partie intermédiaire 44 parallèle aux parties d'extrémité 42 auxquelles elle est reliée par des branches 46 ; ce mode de réalisation permet de mettre en place des moyens pour stabiliser l'élément conducteur 40 dans le boîtier 2, avec par exemple des ouvertures 48 sur la partie intermédiaire 44 coopérant avec des protubérances 48' sur le passage de ligne 10, notamment au niveau du tore 12. De préférence, les branches 46 sont sensiblement orthogonales aux parties d'extrémité 42 et intermédiaire 44 pour servir de butées pour les extrémités 8ᵢ des câbles de raccordement, ce qui permet de limiter la longueur de câble insérée dans la cage 22 et le compteur 1 ; la partie intermédiaire 44 est donc de longueur correspondant à la distance entre bornes 20, 20', pour assurer ainsi une connexion sûre entre le câble 8 et la cage 22.

Pour permettre un montage vertical du compteur 1, l'élément conducteur amovible 40 est monté de façon imperdable et stable dans le boîtier 2 par des moyens adaptés. En particulier, à une extrémité 42₁, la lame 40 comprend des ailettes de maintien 50. Avantageusement, la borne 20₁ recevant cette partie d'extrémité 42₁ de la lame comprend sur ses parois des ergots 52 complémentaires dans lesquelles les ailettes 50 peuvent s'insérer pour un bon positionnement par rapport à la borne de vissage et une bonne tenue mécanique, voire une rigidité, de l'ensemble. De préférence, les ailettes 50 sont de largeur telle qu'elles ne peuvent traverser la cage 22 des bornes 20, de sorte que le montage des éléments conducteurs 40 pour câbles 8 non traversant ne peut être réalisé que dans un sens ; avantageusement, cette configuration tenon/mortaise est localisée au niveau de la borne 20' située au niveau de la face supérieure 6₁ du compteur, par exemple associée à la modification occasionnée par la vis pointeau 34, ce qui supprime le risque de chute.

La solution selon l'invention offre donc à l'utilisateur le choix entre les deux modes de raccordement de façon simple, sans risque de perte de pièces lors du montage, et en conservant la même gamme de section de câble utilisable dans les deux cas. En effet, du fait du dénudement du câble 8 et de la forme sensiblement plane de l'élément conducteur additionnel 40, les mêmes câbles 8, y compris 35 mm², voire 50 mm², peuvent être raccordés dans les deux configurations : la solution selon l'invention permet ainsi de supporter 125 A de façon continue, y compris pour ces compteurs 1 modulaires.

Par exemple, lors du montage sur le réseau, les câbles 8 sont insérés dans le compteur 1 dénué de la lame 40 (figure 4A), les vis pointeaux 34 étant serrées de façon à accéder à l'âme du câble 8. En cas de modification, les câbles 8 sont sectionnés ; le compteur 1, extrait de la ligne, peut être rebranché au même endroit, avec insertion de la lame 40 dans chaque borne 20' et solidarisation ; les extrémités 8ᵢ de câbles sont dénudées et insérées dans les bornes 20 jusqu'à buter contre les branches 46 des barres 40 pour y être serrées ; la mesure de tension peut être directe. Inversement, en cas de débranchement, la barre 40 peut être retirée du compteur 1 pour une utilisation traversante.

Bien que l'invention ait été décrite en référence à un compteur électrique 1 de puissance, elle ne s'y limite pas : d'autres appareils de mesure peuvent être concernés par l'invention, y compris pour des installations sans neutre, voire unipolaires, ou de faible puissance. Par ailleurs, les différents éléments décrits en combinaison peuvent être utilisés seuls, ou dans d'autres combinaisons. Par exemple, bien que décrite de même type mais de configuration différente, les bornes supérieures 20' et inférieures 20 peuvent être identiques, même si les ergots 52 ou vis pointeau 34 ne sont utilisés que pour une borne de chaque paire.

## Revendications

1. Appareil de mesure électrique (1) permettant un raccordement par câble traversant ou non, l'appareil de mesure comprenant un boîtier (2), au moins une paire de bornes (20, 20') définissant un passage de conducteur de courant (10) au sein du boîtier (2), chaque borne (20, 20') étant pourvue d'un organe de serrage (24) d'un câble électrique (8) en son sein, des moyens de mesure (12, 14) adaptés pour mesurer un paramètre du courant circulant dans ledit passage de conducteur de courant (10), et un élément conducteur (40) pouvant être mis en place entre les bornes (20, 20') de la paire de bornes pour les relier électriquement entre elles par ledit passage (10), **caractérisé en ce que** l'élément conducteur (40) est amovible et comprend deux parties d'extrémité (42) destinées à être insérées dans les bornes (20, 20') en laissant un passage de raccordement pour un câble (8) qui peut être serré contre l'élément conducteur (40) par l'organe de serrage (24), une partie intermédiaire (44) entre les parties d'extrémité (42) obstruant le passage de conducteur de courant (10), et des moyens de solidarisation (50, 48) avec l'appareil de mesure (1) de sorte que l'élément conducteur (40) est en position prédéterminée stable lorsqu'il est mis en place.

2. Appareil de mesure selon la revendication 1 dans lequel les moyens de mesure comprennent un tore (12) de mesure du courant localisé autour du passage de conducteur de courant (10) et des moyens (16) de traitement des informations du tore (12).

3. Appareil de mesure selon l'une des revendications 1 ou 2 dans lequel les moyens de mesure comprennent un dispositif (14) de mesure de la tension pouvant être serré sur le passage de conducteur de courant (10) et des moyens (16) de traitement des informations dudit dispositif (14).

4. Appareil de mesure selon la revendication 3 dans lequel le dispositif de mesure de la tension (14) est une vis (34) apte à percer l'isolant d'un câble (8) associée à une borne (20').

5. Appareil de mesure selon l'une des revendications 1 à 4 dans lequel la partie intermédiaire (44) de l'élément conducteur (40) est parallèle à un plan défini par les parties d'extrémité (42) dudit élément conducteur (40), dont la partie intermédiaire (44) est séparée par deux branches (46).

6. Appareil de mesure selon la revendication 5 dans lequel la partie intermédiaire (44) comprend des ouvertures (48) complémentaires d'ergots (48') du passage de conducteur de courant (10) qui peuvent s'y insérer lorsque l'élément conducteur (40) est mis en place dans l'appareil (1).

7. Appareil de mesure selon l'une des revendications 1 à 6 dans lequel les parties d'extrémité (42) de l'élément conducteur ont une section incurvée dans le plan de serrage de l'organe de serrage (24), et dans lequel les bornes (20, 20') ont une forme complémentaire desdites parties d'extrémité (42).

8. Appareil de mesure selon l'une des revendications 1 à 7 dans lequel une extrémité (42₁) de l'élément conducteur (40) comprend des ailettes (50) et une borne (20') comprend des évidements (52) complémentaires pour bloquer l'élément conducteur (40).

9. Appareil de mesure selon l'une des revendications 1 à 8 comprenant deux châssis (36, 38) emboîtés l'un sur l'autre et définissant entre eux des logements pour les moyens de mesure (12) et pour les bornes (20, 20').

10. Appareil de mesure selon l'une des revendications 1 à 9 adapté à un courant multiphasé comprenant une pluralité de paires de bornes (20, 20') et d'éléments conducteurs (40).

11. Appareil de mesure selon l'une des revendications 1 à 10 adapté pour être un compteur d'énergie (1) dans lequel les moyens de mesure comprennent des tores de détection (12) pour des passages de conducteur de courant (10), une vis pointeau (34) associée à chaque passage de conducteur de courant (10), et une carte électronique (16) pour traiter les informations circulant dans les tores (12) et dans les vis pointeaux (34).

## Patentansprüche

1. Elektrisches Messgerät (1), das einen Anschluss durch durchgehendes oder nicht durchgehendes Kabel ermöglicht, wobei das Messgerät ein Gehäuse (2), mindestens ein Klemmenpaar (20, 20'), das einen Durchgang eines Stromleiters (10) innerhalb des Gehäuses (2) definiert, wobei jede Klemme (20, 20') mit einem Klemmelement (24) eines elektrischen Kabels (8) in ihrem Inneren versehen ist, Messmittel (12, 14), die geeignet sind, einen Parameter des Stroms zu messen, der in dem Durchgang des Stromleiters (10) fließt, und ein Leitelement (40) aufweist, das zwischen den Klemmen (20, 20') des Klemmenpaars angeordnet werden kann, um sie durch den Durchgang (10) elektrisch miteinander zu verbinden, **dadurch gekennzeichnet, dass** das Leitelement (40) abnehmbar ist und zwei Endabschnitte (42), die dazu bestimmt sind, in die Klemmen (20, 20') eingeführt zu werden, wobei sie einen Anschlussdurchgang für ein Kabel (8) lassen, das durch das Klemmelement (24) gegen das Leitelement (40) geklemmt werden kann, einen Zwischenabschnitt (44) zwischen den Endabschnitten (42), der den Durchgang des Stromleiters (10) versperrt, und Befestigungsmittel (50, 48) mit dem Messgerät (1) aufweist, derart, dass sich das Leitelement (40) in einer stabilen vorbestimmten Position befindet, wenn es in Position gebracht wird.

2. Messgerät nach Anspruch 1, wobei die Messmittel einen Messtorus (12) des Stroms, der um den Durchgang des Stromleiters (10) herum angeordnet ist, und Mittel (16) zum Verarbeiten der Informationen des Torus (12) aufweisen.

3. Messgerät nach einem der Ansprüche 1 oder 2, wobei die Messmittel eine Vorrichtung (14) zum Messen der Spannung, die auf den Durchgang des Stromleiters (10) geklemmt werden kann, und Mittel (16) zum Verarbeiten der Informationen der Vorrichtung (14) aufweisen.

4. Messgerät nach Anspruch 3, wobei die Vorrichtung zum Messen der Spannung (14) eine Schraube (34) ist, die geeignet ist, die Isolierung eines Kabels (8) zu durchbohren, die mit einer Klemme (20') verbunden ist.

5. Messgerät nach einem der Ansprüche 1 bis 4, wobei der Zwischenabschnitt (44) des Leitelements (40) parallel zu einer Ebene ist, die durch die Endabschnitte (42) des Leitelements (40) definiert ist, dessen Zwischenabschnitt (44) durch zwei Zweige (46) getrennt ist.

6. Messgerät nach Anspruch 5, wobei der Zwischenabschnitt (44) Öffnungen (48) aufweist, die komplementär zu Spornen (48') des Durchgangs des Stromleiters (10) sind, die darin eingefügt werden können, wenn das Leitelement (40) in dem Gerät (1) angeordnet wird.

7. Messgerät nach einem der Ansprüche 1 bis 6, wobei die Endabschnitte (42) des Leitelements einen gekrümmten Abschnitt in der Klemmebene des Klemmelements (24) aufweisen und wobei die Klemmen (20, 20') eine komplementäre Form zu den Endabschnitten (42) aufweisen.

8. Messgerät nach einem der Ansprüche 1 bis 7, wobei ein Endabschnitt (42₁) des Leitelements (40) Flügel (50) aufweist und eine Klemme (20') komplementäre Ausnehmungen (52) aufweist, um das Leitelement (40) zu blockieren.

9. Messgerät nach einem der Ansprüche 1 bis 8, umfassend zwei Gestelle (36, 38), die übereinander gesetzt sind und zwischen sich Aufnahmen für die Messmittel (12) und für die Klemmen (20, 20') bilden.

10. Messgerät nach einem der Ansprüche 1 bis 9, das für einen mehrphasigen Strom geeignet ist, umfassend mehrere Klemmenpaare (20, 20') und Leitelemente (40).

11. Messgerät nach einem der Ansprüche 1 oder 10, das geeignet ist, um ein Energiezähler (1) zu sein, wobei die Messmittel Erfassungstori (12) für Durchgänge des Stromleiters (10), eine Madenschraube (34) die mit jedem Durchgang des Stromleiters (10) verbunden ist, und eine elektronische Karte (16) aufweisen, um die Informationen zu verarbeiten, die in den Tori (12) und in den Madenschrauben (34) zirkulieren.

## Claims

1. Electrical measurement device (1) enabling a connection by way of a through or non-through cable, the measurement device comprising a housing (2), at least one pair of terminals (20, 20') defining a current conduction passage (10) within the housing (2), each terminal (20, 20') being provided with a unit (24) for clamping an electrical cable (8) inside it, measurement means (12, 14) designed to measure a parameter of the current flowing in said current conduction passage (10), and a conductive element (40) able to be installed between the terminals (20, 20') of the pair of terminals so as to link them electrically to one another through said passage (10), **characterized in that** the conductive element (40) is removable and comprises two end parts (42) that are intended to be inserted into the terminals (20, 20') while leaving a connection passage for a cable (8) that is able to be clamped against the conductive element (40) by the clamping unit (24), an intermediate part (44) between the end parts (42) blocking off the current conduction passage (10), and means (50, 48) for attachment to the measurement device (1) such that the conductive element (40) is in a predetermined stable position when it is installed.

2. Measurement device according to Claim 1, wherein the measurement means comprise a current measurement torus (12) located around the current conduction passage (10) and means (16) for processing the information from the torus (12).

3. Measurement device according to either of Claims 1 and 2, wherein the measurement means comprise a voltage measurement device (14) able to be clamped to the current conduction passage (10) and means (16) for processing the information from said device (14).

4. Measurement device according to Claim 3, wherein the voltage measurement device (14) is a screw (34), able to pierce the insulation of a cable (8), associated with a terminal (20').

5. Measurement device according to one of Claims 1 to 4, wherein the intermediate part (44) of the conductive element (40) is parallel to a plane predefined by the end parts (42) of said conductive element (40) from which the intermediate part (44) is separated by two branches (46).

6. Measurement device according to Claim 5, wherein the intermediate part (44) comprises apertures (48) complementary to lugs (48') of the current conduction passage (10) that are able to be inserted thereinto when the conductive element (40) is installed in the device (1).

7. Measurement device according to one of Claims 1 to 6, wherein the end parts (42) of the conductive element have a section that is curved in the clamping plane of the clamping unit (24), and wherein the terminals (20, 20') have a form complementary to said end parts (42).

8. Measurement device according to one of Claims 1 to 7, wherein one end (42₁) of the conductive element (40) comprises fins (50) and one terminal (20') comprises complementary recesses (52) for blocking the conductive element (40).

9. Measurement device according to one of Claims 1 to 8, comprising two frames (36, 38) fitted one on top of the other and defining between them housings for the measurement means (12) and for the terminals (20, 20').

10. Measurement device according to one of Claims 1 to 9, designed for a multiphase current comprising a plurality of pairs of terminals (20, 20') and of conductive elements (40).

11. Measurement device according to one of Claims 1 to 10, designed to be an energy meter (1) in which the measurement means comprise detection tori (12) for current conduction passages (10), a grub screw (34) associated with each current conduction passage (10), and an electronic board (16) for processing the information flowing in the tori (12) and in the grub screws (34).
